# EUROPÄISCHE PATENTSCHRIFT

(11) **EP 1 229 556 B1**
(45) Veröffentlichungstag und Bekanntmachung des Hinweises auf die Patenterteilung: **06.05.2009**
(21) Anmeldenummer: 02001819.8
(22) Anmeldetag: 25.01.2002
(51) Int. Cl.: H01B 7/40, B60R 16/02

(54) **Elektrische Leitung**
Electrical line
Ligne électrique

(30) Priorität: 05.02.2001 DE 10105089
(43) Veröffentlichungstag der Anmeldung: 07.08.2002
(73) Patentinhaber: Delphi Technologies, Inc., Troy, MI 48007 (US)
(72) Erfinder: Adam, Frank H, 42369 Wuppertal (DE); Diegmann, Wolfgang, 42279 Wuppertal (DE); Tiedeck, Rüdiger, 40764 Langenfeld (DE)
(74) Vertreter: Denton, Michael John

(56) Entgegenhaltungen:
- EP-A- 0 813 277
- GB-A- 2 256 977
- US-A- 4 602 191
- US-A- 6 036 259
- PATENT ABSTRACTS OF JAPAN vol. 2002, no. 02, 2. April 2002 (2002-04-02) & JP 2001 291433 A (AUTO NETWORK GIJUTSU KENKYUSHO:KK;SUMITOMO WIRING SYST LTD; SUMITOMO E), 19. Oktober 2001 (2001-10-19)

## Beschreibung

Die Erfindung betrifft eine elektrische Leitung mit zumindest einem elektrisch leitenden Material, das in wenigstens ein elektrisch isolierendes Material eingebettet ist, sowie Verfahren und Anordnungen zum Herstellen derartiger elektrischer Leitungen.

Grundsätzlich sind elektrische Leitungen der eingangs genannten Art bekannt. Unter anderem können solche elektrischen Leitungen als flexible Flachbandkabel (FFC) oder als flexible gedruckte Schaltkreise (FPC) ausgebildet sein. Derartige elektrische Leitungen gelangen beispielsweise in der Automobilindustrie zum Einsatz, wo sie z.B. zwischen einem Autodach oder einer Autotür und einer Montagefläche, insbesondere einer Innenverkleidung, die eine textilartige Oberfläche aufweist, verlegt werden.

Typischerweise werden die elektrischen Leitungen dabei auf dem Untergrund, beispielsweise auf der Innenverkleidung verklebt. Dabei kann jedoch das Problem auftreten, dass der Klebstoff aufgrund von Silikonölen, die bei der Herstellung der Innenverkleidung eingesetzt werden, nicht zuverlässig haftet. Weiterhin lassen sich verklebte elektrische Leitungen nicht ohne Probleme demontieren, wenn beispielsweise Autoteile, an denen solche elektrischen Leitungen verlegt sind, zur Abfallreduzierung einer Materialtrennung und anschließender Materialwiederverwertung zugeführt werden sollen.

Der Erfindung liegt die Aufgabe zugrunde, eine in einem Fahrzeugraum einfach und kostengünstig verlegbare elektrische Leitung zu schaffen. Darüber hinaus ist es Aufgabe der Erfindung, ein Verfahren und eine Anordnung zum Herstellen einer derartigen elektrischen Leitung bereitzustellen.

Zur Lösung der ersten Aufgabe ist eine elektrische Leitung mit den Merkmalen des Anspruchs 1 vorgesehen. Sie zeichnet sich dadurch aus, dass ihre Oberfläche zumindest bereichsweise direkt und ohne Klebeverbindung in das elektrisch isolierte Material integrierte klettverschlussartige Haken und/oder Ösen aufweist.

Aufgrund dieser Ausbildung lassen sich erfindungsgemäße elektrische Leitungen mittels einer klettverschlussartigen Verbindung an dafür vorgesehenen Montageflächen, insbesondere an Innenverkleidungen mit textilartigen Oberflächen, befestigen. Problematische Klebeverbindungen werden somit überflüssig und durch eine haltbare Klettverbindung ersetzt. Dies bedeutet eine einfach zu handhabende, billige und schnelle Verlegung der elektrischen Leiter im Fahrzeugraum.

Entsprechend problemlos lassen sich auf diese Weise verlegte elektrische Leitungen auch wieder entfernen, was besonders in Hinblick auf Müllvermeidung und die Trennung und Wiederverwertung von Werkstoffen ein Aspekt ist, der nicht nur in der Automobilproduktion einen aufgrund von Umweltauflagen zunehmend wichtigeren Kostenfaktor darstellt.

Da die klettverschlussartigen Haken und/oder Ösen direkt und ohne Klebeverbindung in das elektrisch isolierte Material integriert sind, muss kein zusätzliches Material mit Haken oder Ösen auf die elektrische Leitung aufgebracht werden, was die Dicke der elektrischen Leitung unnötig anwachsen ließe und eine unauffällige Verlegung der elektrischen Leitung möglicherweise unmöglich machen würde. Der ursprüngliche Querschnitt der elektrischen Leitung kann folglich beibehalten werden.

Da die Haken und/oder Ösen der elektrischen Leitung erfindungsgemäß ohne Klebeverbindung in das elektrisch isolierende Material integriert sind, können zusätzliche Herstellungsschritte wie das Auftragen und Trocknen von Klebstoffen eingespart werden.

Darüber hinaus lassen sich Anwendungen realisieren, in denen eine Innenverkleidung mit vliesartiger Oberfläche allein mittels einer Klettverbindung an einer Montagefläche, z.B. an einem Autodach, befestigt wird. An der Montagefläche angebrachte, mit Haken versehene elektrische Leitungen können dabei als Befestigungspunkte für die Innenverkleidung dienen.

Im Rahmen dieser Erfindung wird unter klettverschlussartigen Haken und Ösen jede Struktur verstanden, die eine Fixierung nach Art eines Klettverschlusses ermöglicht. Als Haken können beispielsweise auch Strukturen in Form von Harpunenspitzen, Pilzköpfen oder dergleichen dienen.

Vorteilhafte Ausführungsformen der erfindungsgemäßen elektrischen Leitung sind den Unteransprüchen, der Beschreibung und der Zeichnung zu entnehmen.

So kann bei einer ersten Variante der erfindungsgemäßen elektrischen Leitung das elektrisch leitende Material laminatartig zwischen zumindest zwei Schichten wenigstens eines elektrisch isolierenden Materials eingebettet sein, wobei zumindest eine der beiden Schichten durch eine wenigstens bereichsweise jeweils klettverschlussartige Haken oder Ösen aufweisende Struktur gebildet ist. Ein derartiger sandwichartiger Schichtaufbau eignet sich besonders gut für eine elektrische Leitung mit flachem Querschnitt, wie beispielsweise für ein flexibles Flachbandkabel (FFC) oder einen flexiblen gedruckten Schaltkreis (FPC). Die Haken oder Ösen aufweisende Struktur wird dabei nicht zusätzlich auf ein bereits vorhandenes elektrisch isolierendes Material aufgebracht, sondern wird anstelle eines elektrisch isolierenden Materials selbst als Isolationsmaterial verwendet. Eine flache Bauhöhe der elektrischen Leitung kann auf diese Weise beibehalten werden.

Vorteilhafterweise weist zumindest eine der beiden Schichten eine Kunststofffolie oder entsprechend einer weiteren Ausführungsform der elektrischen Leitung ein Gewebematerial auf. Beide Materialen sind günstig in der Herstellung und leicht zu verarbeiten. Im einfachsten Fall kann daher ein gewöhnliches Klettverschlussband als elektrisch isolierendes Material dienen. Da im Vergleich zur herkömmlichen Herstellung eingangs genannter elektrischer Leitungen gewöhnliche Kunststofffolien oder Gewebematerialien lediglich durch solche ersetzt werden, die Haken oder Ösen aufweisen, fallen keine zusätzlichen Prozessschritte bei der Herstellung erfindungsgemäßer elektrischer Leiter an.

Bevorzugt ist die eine Schicht eine Haken aufweisende und die andere Schicht eine Ösen aufweisende Struktur. Gleichermaßen können beide Schichten entweder Haken oder Ösen aufweisende Strukturen sein. In beiden Fällen ist eine beidseitige Befestigung der erfindungsgemäßen elektrischen Leitung an entsprechend ausgebildeten Innenverkleidungen oder Funktionsflächen ermöglicht.

Die erfindungsgemäße elektrische Leitung kann ein flexibles Flachbandkabel (FFC) oder eine flexible gedruckte Schaltung (FPC) sein. Derartige elektrische Leitungen lassen sich problemlos an gekrümmten oder dreidimensional ausgeprägten Oberflächen anbringen, wie sie beispielsweise in Autodächern oder Autotüren vorkommen.

Gemäß einer zweiten vorteilhaften Variante der erfindungsgemäßen elektrischen Leitung ist das elektrisch isolierende Material zumindest bereichsweise mit einer klettverschlussartige Haken oder Ösen aufweisenden Struktur versehen, die mit dem elektrisch isolierenden Material eine Schmelzverbindung bildet.

Eine derartige elektrische Leitung ist insbesondere dann auf besonders einfache Weise herstellbar, wenn im Herstellungsprozess der elektrischen Leitung ein Aufschmelzen des elektrisch isolierenden Materials vorgesehen ist, wie es beispielsweise in einer Strangpressvorrichtung der Fall ist. Das Aufschmelzen des elektrisch isolierenden Materials kann dann zur Schaffung einer haltbaren Schmelzverbindung zwischen der aufzubringenden Struktur und dem elektrisch isolierenden Material ausgenutzt werden. Auf zusätzliche Klebstoffe kann folglich verzichtet werden. Diese Art von elektrischer Leitung lässt sich mit einem flachen oder runden Querschnitt realisieren.

Gemäß einer dritten vorteilhaften Variante der erfindungsgemäßen elektrischen Leitung sind die klettverschlussartigen Haken aus dem elektrisch isolierenden Material selbst gebildet. Da die Haken direkt in dem elektrisch isolierenden Material erzeugt werden, braucht keine zusätzliche Haken aufweisende Struktur auf die Oberfläche der elektrischen Leitung aufgebracht zu werden. Auf diese Weise wird der Einsatz von Material reduziert. Gleichzeitig kann eine geringe Bauhöhe der elektrischen Leitung beibehalten werden, da kein Material zusätzlich auf die Oberfläche der elektrischen Leitung aufgebracht wird. Auch diese Art von elektrischer Leitung lässt sich sowohl mit flachem als auch mit rundem Querschnitt realisieren.

Weiterer Gegenstand der Erfindung ist ein Verfahren zum Versehen einer Oberfläche einer elektrischen Leitung mit klettverschlussartigen Haken oder Ösen, bei dem wenigstens ein elektrisch leitfähiges Material in zumindest ein elektrisch isolierendes Material eingebettet wird, wobei das elektrisch isolierende Material zumindest bereichsweise durch wenigstens eine klettverschlussartige Haken oder Ösen aufweisende Struktur gebildet wird. Durch ein derartiges Verfahren lassen sich vor allem die erfindungsgemäßen elektrischen Leitungen der ersten und zweiten Variante auf einfache Weise realisieren.

Gemäß einer ersten vorteilhaften Variante des erfindungsgemäßen Verfahrens wird das elektrisch leitfähige Material durch einen Laminiervorgang zwischen zumindest zwei Schichten wenigstens eines elektrisch isolierenden Materials eingebettet, wobei mindestens eine der Schichten durch eine wenigstens bereichsweise klettverschlussartige Haken oder Ösen aufweisende Struktur gebildet wird. Auf diese Weise lassen sich insbesondere elektrische Leitungen mit flachem Querschnitt, wie beispielsweise flexible Flachbandkabel oder flexible gedruckte Schaltkreise, realisieren, welche die voranstehend aufgeführten Vorteile der erfindungsgemäßen elektrischen Leitung der ersten Variante aufweisen.

Gemäß einer zweiten vorteilhaften Variante des erfindungsgemäßen Verfahrens wird eine auf ihrer einen Seite klettverschlussartige Haken oder Ösen aufweisende Struktur mit ihrer anderen Seite zumindest abschnittsweise auf die Oberfläche des elektrisch isolierenden Materials aufgebracht, wobei das elektrisch isolierende Material bei Aufbringen der Struktur eine derart hohe Temperatur aufweist, dass es mit der Struktur eine Schmelzverbindung eingeht. Diese zweite Variante des erfindungsgemäßen Verfahrens eignet sich sowohl für elektrische Leitungen mit flachem Querschnitt als auch für elektrische Leitungen mit rundem Querschnitt. Die mittels dieses Verfahrens hergestellten elektrischen Leitungen weisen die Vorteile der voranstehend beschriebenen elektrischen Leitungen der zweiten Variante auf.

Weiterer Gegenstand der Erfindung ist ein Verfahren zum Versehen einer Oberfläche einer elektrischen Leitung mit klettverschlussartigen Haken, bei dem wenigstens ein elektrisch leitfähiges Material in zumindest ein elektrisch isolierendes Material eingebettet wird und zumindest bereichsweise direkt in dem elektrisch isolierenden Material selbst klettverschlussartige Haken gebildet werden. Durch dieses Verfahren (der sog. dritte Variante) lassen sich erfindungsgemäße elektrische Leitungen der dritten Variante herstellen.

Gemäß einer bevorzugten Ausführungsform dieses Verfahrens werden in dem elektrisch isolierenden Material selbst mittels eines ersten Strukturierungsmittels nadelartige Strukturen erzeugt. Die nadelartigen Strukturen können dabei durch eine erste Walze erzeugt werden, die mit einem Oberflächenbereich des elektrisch isolierenden Materials in Berührung gebracht wird. Die Ausbildung von nadelartigen Strukturen in dem elektrisch isolierenden Material ist ein Vorgang, der sich auf einfache Weise durchführen und unter Verwendung der Walze als Strukturierungsmittel besonders gut in einem kontinuierlichen Herstellungsprozess der erfindungsgemäßen elektrischen Leitung integrieren lässt.

Bevorzugt erfolgt die Bildung der nadelartigen Strukturen bei einer Temperatur des elektrisch isolierenden Materials, bei der das elektrisch isolierende Material leicht verformbar ist. Auf diese Weise lassen sich die nadelartigen Strukturen besonders leicht erzeugen.

Vorteilhafterweise werden die Spitzen der nadelartigen Strukturen mittels eines zweiten Strukturierungsmittels zu Haken umgeformt. Erst durch das Umformen der nadelartigen Strukturen zu Haken wird die Oberfläche der elektrischen Leitung derart ausgebildet, dass sie zusammen mit einer Ösen aufweisenden Montagefläche eine klettverschlussartige Verbindung eingehen kann.

Bevorzugt werden die Spitzen der nadelartigen Strukturen durch eine zur Längserstreckung der elektrischen Leitung parallele Relativbewegung der elektrischen Leitung bezüglich einer zweiten Walze umgebogen oder verbreitert. Durch das Verwenden einer Walze zum Umbiegen oder Verbreitern der Haken und der zur Längserstreckung der elektrischen Leitung parallelen Relativbewegung lässt sich auch dieser Umformungsvorgang besonders einfach in einem kontinuierlichen Herstellungsprozess der erfindungsgemäßen elektrischen Leitung der dritten Variante integrieren.

Vorteilhafterweise erfolgt das Umformen der Spitzen der nadelartigen Strukturen nach einer Abkühlung des elektrisch isolierenden Materials auf eine Temperatur, bei der die nadelartigen Strukturen erstarren, wobei das zweite Strukturierungsmittel eine zur Verformung des elektrisch isolierenden Materials benötigte Temperatur aufweist. Auf diese Weise kann sichergestellt werden, dass lediglich die Spitzen der nadelartigen Strukturen umgeformt werden und die nadelartigen Strukturen aufgrund temperaturbedingter leichter Verformbarkeit nicht vollständig deformiert werden.

Gemäß einer besonders vorteilhaften Ausführungsform der erfindungsgemäßen Verfahren der zweiten und dritten Variante wird zumindest ein elektrisch leitfähiger Materialstrang in einer Strangpressvorrichtung mit wenigstens einer Kunststoffummantelung versehen. Das Isolieren eines elektrisch leitfähigen Materials in einer Strangpressvorrichtung ist ein kontinuierlicher Prozess, der sich besonders gut mit den Strukturierungsverfahren der Variante 2 und 3 kombinieren lässt.

Nach einer besonders bevorzugten Ausführungsform der erfindungsgemäßen Verfahren der Variante 2 und 3 erfolgt das Versehen der elektrischen Leitung mit den klettverschlussartigen Haken oder Ösen unmittelbar nach dem Austreten der elektrischen Leitung aus einer Strangpressvorrichtung. In diesem Fall wird die erhöhte Temperatur, die das elektrisch isolierende Material bei Austritt aus der Strangpressvorrichtung aufweist, direkt zum Eingehen einer Schmelzverbindung zwischen dem elektrisch isolierenden Material und einer Haken oder Ösen aufweisenden Struktur oder zum Erzeugen nadelartiger Strukturen in dem elektrisch isolierenden Material ausgenutzt. Ein zusätzlicher Prozessschritt zum Aufheizen des elektrisch isolierenden Materials kann somit eingespart werden.

Weiterer Gegenstand der Erfindung ist eine Anordnung zum Aufbringen einer klettverschlussartigen Haken oder Ösen aufweisenden Struktur in zumindest einem Oberflächenbereich einer elektrischen Leitung, mit einer Strangpressvorrichtung zum Versehen zumindest eines elektrisch leitfähigen Materialstrangs mit wenigstens einer Kunststoffummantelung und einer im Ausgangsbereich der Strangpressvorrichtung angeordneten Andrückwalze zum Andrücken einer an ihrer der elektrischen Leitung abgewandten Seite klettverschlussartige Haken oder Ösen aufweisenden Struktur an die elektrische Leitung, wobei die elektrische Leitung mit der Struktur eine Schmelzverbindung eingeht. Eine derartige Anordnung ist besonders gut geeignet, um erfindungsgemäße Leitungen der zweiten Variante herzustellen.

Weiterer Gegenstand der Erfindung ist eine Anordnung zum Versehen zumindest eines Oberflächenbereiches einer elektrischen Leitung mit klettverschlussartigen Haken, mit einer Strangpressvorrichtung zum Versehen zumindest eines elektrisch leitfähigen Materialstrangs mit wenigstens einer Kunststoffummantelung, einem im Ausgangsbereich der Strangpressvorrichtung angeordneten ersten und zweiten Strukturierungsmittel, einer zwischen den Strukturierungsmitteln angeordneten Kühlvorrichtung zum Abkühlen der elektrischen Leitung und einer Vorschubeinrichtung, um die elektrische Leitung an den Strukturierungsmitteln vorbei und durch die Kühlvorrichtung hindurch zu führen. In einer derartigen Anordnung lassen sich erfindungsgemäße elektrische Leitungen der dritten Variante auf einfache Weise herstellen.

Nachfolgend werden die verschiedenen Aspekte der Erfindung rein beispielhaft anhand vorteilhafter Ausführungsformen und unter Bezugnahme auf die beigefügte Zeichnung beschrieben. Es zeigen:
- Fig. 1a - c: jeweils einen schematischen Querschnitt durch unterschiedliche Ausführungsformen einer erfindungsgemäßen elektrischen Leitung der ersten Variante;
- Fig. 2a - d: jeweils einen schematischen Querschnitt durch unterschiedliche Ausführungsformen einer erfindungsgemäßen elektrischen Leitung der zweiten oder dritten Variante;
- Fig. 3: eine perspektivische Ansicht einer erfindungsgemäßen Anordnung zur Herstellung einer erfindungsgemäßen elektrischen Leitung der zweiten Variante;
- Fig. 4: eine perspektivische Ansicht einer erfindungsgemäßen Anordnung zur Herstellung einer erfindungsgemäßen Leitung der dritten Variante; und
- Fig. 5: eine hakenartige Oberflächenstruktur (a) und eine pilzförmig verbreiterte Oberflächenstruktur (b) einer erfindungsgemäßen elektrischen Leitung der dritten Variante.

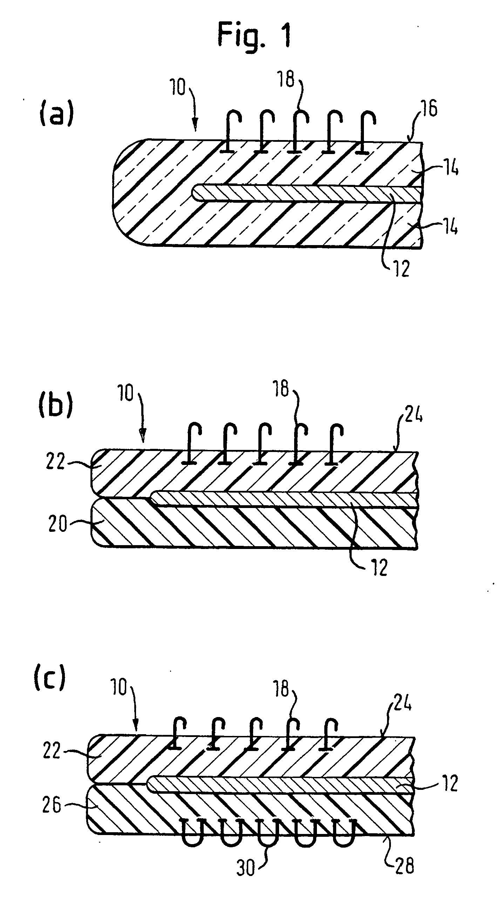

Fig. 1a zeigt einen Querschnitt durch eine erfindungsgemäße elektrische Leitung 10 einer ersten Variante, die ein elektrisch leitendes Material 12 aufweist, beispielsweise eine oder mehrere Kupferbahnen, das sandwichartig zwischen zwei Schichten aus einem elektrisch isolierenden Material 14 angeordnet ist. Durch einen Laminiervorgang werden die beiden Schichten des elektrisch isolierenden Materials 14 miteinander und mit dem elektrischen leitenden Material 12 verbunden. Da die beiden Schichten aus demselben elektrisch isolierenden Material 14 gebildet sind, wird auf diese Weise eine homogene Isolationsummantelung des elektrisch leitenden Materials 12 geschaffen.

Eine der beiden Schichten weist auf ihrer Außenseite 16 klettverschlussartige Haken 18 auf, die als Teil eines Klettverschlusses wirken. Die Haken 18 sind fest in dem isolierenden Material 14 der einen Schicht verankert. Mit Hilfe dieser Haken 18 lässt sich die elektrische Leitung 10 an einer mit Ösen versehenen Montagefläche (nicht gezeigt), beispielsweise einem Vlies, befestigen, indem die elektrische Leitung 10 und die Montagefläche eine Klettverbindung eingehen.

Fig. 1b zeigt eine alternative Ausführungsform der elektrischen Leitung 10 der ersten Variante, bei der ein elektrisch leitendes Material 12 zwischen zwei Schichten aus unterschiedlichen isolierenden Materialien 20, 22 eingebettet ist. Die elektrische Leitung 10 wird durch Laminieren des elektrisch leitenden Materials 12 zwischen den elektrisch isolierenden Materialschichten 20, 22 hergestellt, wobei die Schichten jeweils eine Folie oder ein Textilband aus Kunststoff aufweisen können. Die Außenseite 24 der einen elektrisch isolierenden Materialschicht 22 ist dabei bereichsweise mit im Material 22 verankerten klettverschlussartigen Haken 18 versehen.

In Fig. 1c ist ein elektrische Leitung 10 der ersten Variante gezeigt, bei der ein elektrisch leitendes Material 12 ebenfalls zwischen zwei Schichten aus unterschiedlichen isolierenden Materialien 22, 26 laminiert ist. Bei diesem Ausführungsbeispiel weist die eine Schicht auf ihrer Außenseite 24 im elektrisch isolierenden Material 22 verankerte Haken 18 und die andere Schicht auf ihrer Außenseite 28 im elektrisch isolierenden Material 26 verankerte Ösen 30 auf. Auch hier kann es sich bei den Schichten z.B. um Klettverschlussbänder handeln, die auf ihren Außenseiten jedoch komplementär zueinander ausgebildet sind.

Selbstverständlich sind weitere (nicht gezeigte) Ausführungsformen der elektrischen Leitung 10 der ersten Variante denkbar, bei denen die Schichten des elektrisch isolierenden Materials jeweils beide entweder klettverschlussartige Haken oder Ösen aufweisen. Eine gleichzeitige Befestigung an zwei entsprechend ausgebildeten Montageflächen wird auf diese Weise ermöglicht. Aufgrund des sandwichartigen Schichtaufbaus eignet sich die voranstehend beschriebene erste Variante der erfindungsgemäßen elektrischen Leitung besonders für elektrische Leitungen mit flachem Querschnitt, wie beispielsweise flexible Flachbandkabel (FFC) oder flexible gedruckte Schaltkreise (FPC).

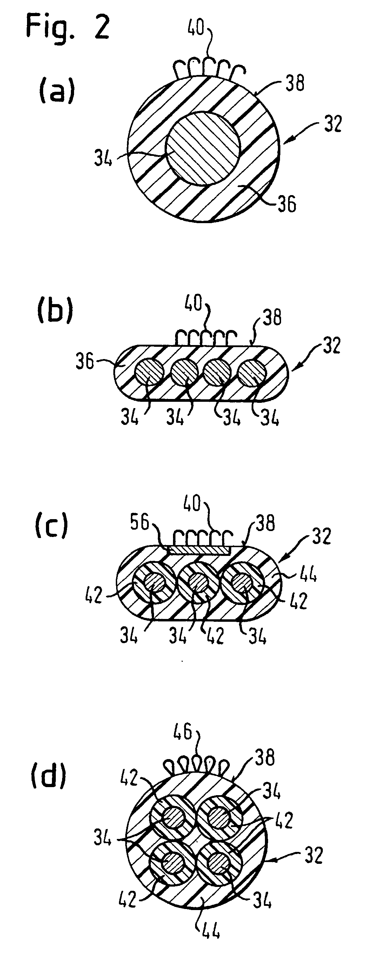

In Fig. 2 sind verschiedene Ausführungsformen der erfindungsgemäßen elektrischen Leitung gemäß der zweiten und dritten Variante dargestellt. Fig. 2a zeigt eine elektrische Leitung 32 mit einem runden Querschnitt. Den Kern der elektrischen Leitung 32 bildet ein Strang eines elektrisch leitenden Materials 34, der mit einem elektrisch isolierenden Material 36, beispielsweise einem Kunststoff, ummantelt ist. Eine äußere Oberfläche 38 des elektrisch isolierenden Materials 36 ist bereichsweise mit klettverschlussartigen Haken 40 versehen, wobei die Haken 40 direkt in das elektrisch isolierende Material 36 integriert sind.

Wie in Fig. 2b dargestellt ist, kann eine erfindungsgemäße elektrische Leitung 32 auch mehrere, im gezeigten Ausführungsbeispiel vier, in einer Ebene nebeneinander angeordnete und parallel zueinander verlaufende Stränge eines elektrisch leitenden Materials 34 aufweisen. Die elektrisch leitenden Materialstränge 34 sind in ein elektrisch isolierendes Material 36 eingebettet. Insgesamt ergibt sich auf diese Weise ein flacher Querschnitt der elektrischen Leitung 32. An ihrer Oberfläche 38 ist die elektrische Leitung 32 bereichsweise mit klettverschlussartigen Haken 40 versehen, die direkt in das elektrisch isolierende Material 36 integriert sind.

Fig. 2c zeigt eine erfindungsgemäße elektrische Leitung 32 mit drei in einer Ebene nebeneinander angeordneten Strängen eines elektrisch leitenden Materials 34. Jeder einzelne Strang des elektrisch leitenden Materials 34 ist jeweils von einem ersten elektrisch isolierenden Material 42 umgeben. Zusätzlich sind die von dem ersten isolierenden Material 42 umgebenden elektrisch leitenden Materialstränge 34 in ein zweites elektrisch isolierendes Material 44 eingebettet. Auch diese elektrische Leitung 32 weist insgesamt einen flachen Querschnitt auf und ist in einem flachen Abschnitt ihrer Oberfläche 38 bereichsweise mit einer klettverschlussartige Haken 40 aufweisenden Struktur 56 versehen, die mit dem zweiten elektrisch isolierenden Material 44 eine Schmelzverbindung bildet.

Bei der in Fig. 2d dargestellten Ausführungsform der erfindungsgemäßen elektrischen Leitung 32 sind, ähnlich wie bei der in der Fig. 2c gezeigten Ausführungsform, vier Stränge eines elektrisch leitenden Materials 34 jeweils von einem ersten elektrisch isolierenden Material 42 umgeben und zusätzlich in ein zweites elektrisch isolierendes Material 44 eingebettet. Bei diesem Ausführungsbeispiel sind die bei diesem Ausführungsbeispiel vier Stränge des elektrisch leitenden Materials 34 jedoch verseilt, so dass die elektrische Leitung 32 insgesamt einen runden Querschnitt aufweist. In einem Bereich ihrer Oberfläche 38 ist die elektrische Leitung 32 mit klettverschlussartigen Ösen 46 versehen, die direkt in das zweite elektrisch isolierende Material 44 integriert sind.

Die in Fig. 2a-d gezeigten elektrischen Leitungen 32 können gemäß den erfindungsgemäßen Verfahren der zweiten oder dritten Variante hergestellt werden.

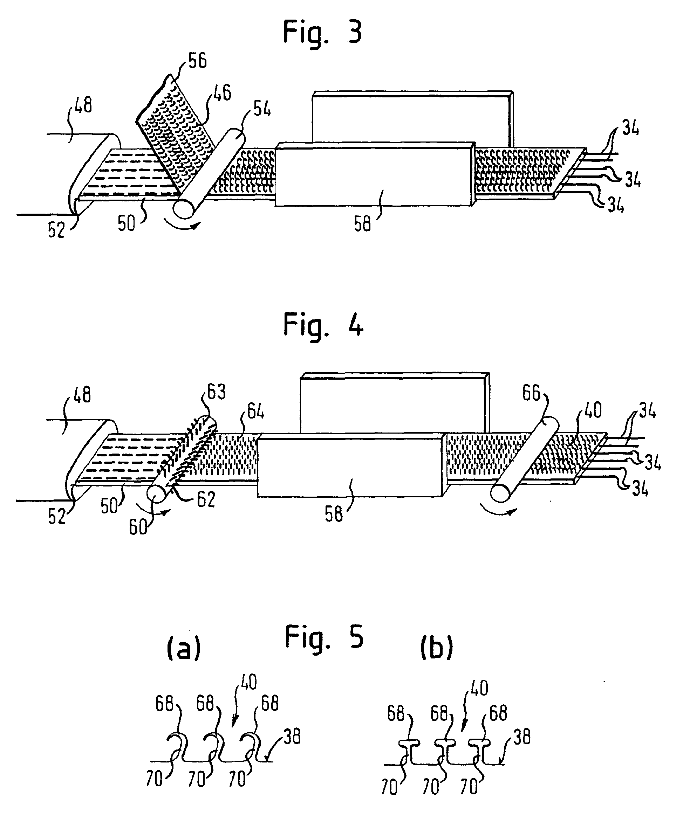

Bei dem Verfahren der zweiten Variante (Fig. 3) wird bzw. werden der Strang oder die Stränge des elektrisch leitenden Materials 34 in einer Strangpressvorrichtung mit einem elektrisch isolierenden Material 36 oder mit ersten und zweiten elektrisch isolierenden Materialien 42, 44 umgeben, beispielsweise mit einer Kunststoffummantelung oder mehreren Kunststoffummantelungen versehen. Anschließend wird eine klettverschlussartige Haken oder Ösen aufweisende Struktur 56, beispielsweise ein textiles Klettband, auf die elektrische Leitung 32 derart aufgebracht, dass die Struktur mit dem äußeren elektrisch isolierenden Material eine Schmelzverbindung eingeht.

Eine Anordnung zum Durchführen dieses erfindungsgemäßen Verfahrens der zweiten Variante ist in Fig. 3 dargestellt. In einer Strangpressvorrichtung 48, auch Extruder genannt, werden mehrere Stränge eines elektrisch leitenden Materials 34 mit einer Isolationsummantelung 50 aus einem elektrisch isolierenden Material 36 oder aus mehreren elektrisch isolierenden Materialien 42,44 versehen, beispielsweise mit Kunststoff ummantelt.

In Fig. 3 sind beispielhaft sechs, in einer Ebene nebeneinander liegende Stränge 34 dargestellt. Selbstverständlich können die Anzahl und die Anordnung der Stränge variieren. Ebenso lassen sich bei diesem Verfahren auch flexible gedruckte Schaltkreise (FPC) mit Haken oder Ösen versehen.

Innerhalb der Strangpressvorrichtung 48 herrscht zumindest abschnittsweise eine derart hohe Temperatur, dass das elektrisch isolierende Material 36, 44 einen zumindest annähernd fließfähigen Zustand erreicht, um die zu isolierenden Stränge des elektrisch leitenden Materials 34 homogen zu umgeben.

Im Bereich einer Austrittsöffnung 52 der Strangpressvorrichtung 48 ist eine Andrückwalze 54 angeordnet, deren Längsachse quer zur Längserstreckung der elektrischen Leitung 32 orientiert ist. Die Andrückwalze 54 dient zum Andrücken einer klettverschlussartige Ösen 46 aufweisenden Struktur 56, beispielsweise eines textilen Klettbandes, an die Oberfläche der elektrischen Leitung 32. Gleichermaßen könnte die Struktur 56 auch klettverschlussartige Haken 40 aufweisen.

Die aus der Strangpressvorrichtung 48 austretende elektrische Leitung 32 weist im Bereich der Andrückwalze 54 eine derart hohe Temperatur auf, dass die Struktur 56 mit der Isolationsummantelung 50 der elektrischen Leitung 32 eine Schmelzverbindung eingeht. Mittels einer nicht gezeigten Vorschubeinrichtung wird die elektrische Leitung 32 in Richtung ihrer Längserstreckung aus der Strangpressvorrichtung 48 heraus, unter der Andrückwalze 54 hindurch und anschließend durch eine Kühlvorrichtung 58 hindurch geführt, die der Fixierung der Schmelzverbindung zwischen der Struktur 56 und der Isolationsummantelung 50 sowie der Abkühlung der elektrischen Leitung 32 insgesamt dient.

Während sich mit der soeben beschriebenen Anordnung der Fig. 3 erfindungsgemäß sowohl Haken als auch Ösen aufweisende elektrische Leitungen der zweiten Variante herstellen lassen, ermöglicht die in Fig. 4 dargestellte Anordnung die Realisierung der lediglich Haken aufweisenden Variante 3 der erfindungsgemäßen elektrischen Leitung 32. Die in Fig. 4 gezeigte Anordnung weist ebenfalls eine Strangpressvorrichtung 48 auf, um ein elektrisch leitendes Material 34, in diesem Ausführungsbeispiel sechs in einer Ebene nebeneinander liegende elektrisch leitfähige Kabelstränge, mit einer Isolationsummantelung 50, beispielsweise einer Kunststoffummantelung, zu versehen. Auch in dieser Strangpressvorrichtung 48 herrscht zumindest abschnittsweise eine erhöhte Temperatur, um ein Aufschmelzen eines Oberflächenbereiches der Isolationsummantelung 50 zu erreichen.

Im Bereich der Austrittsöffnung 52 der Strangpressvorrichtung 48 ist eine Strukturierungswalze 60 vorgesehen, deren Längsachse quer zur Längserstreckung der elektrischen Leitung 32 orientiert ist. Die Mantelfläche 62 der Strukturierungswalze 60 ist mit Nadelöffnungen 63 versehen und steht mit der elektrischen Leitung 32 in Berührung, um in der Isolationsummantelung 50 durch einen prägeähnlichen Vorgang nadelartige Strukturen 64 zu erzeugen.

Eine einfache Erzeugung der nadelartigen Strukturen 64 wird durch eine leichte Verformbarkeit der Isolationsummantelung 50 begünstigt, die wiederum durch eine im Bereich des Schmelzpunktes der Isolationsummantelung 50 liegende Temperatur der Isolationsummantelung 50 sichergestellt wird.

Erfindungsgemäß wird die erhöhte Temperatur der Isolationsummantelung 50 im Bereich der Strukturierungswalze 60 dadurch gewährleistet, dass die Strukturierungswalze 60 im Bereich der Austrittsöffnung 52 der Strangpressvorrichtung 48 angeordnet ist. Dadurch findet die Strukturierung der Oberfläche der elektrischen Leitung 32 statt, solange die elektrischen Leitung 32 nach ihrem Austritt aus der Strangpressvorrichtung 48 eine erhöhte Temperatur aufweist.

Ein Aufheizen der elektrischen Leitung 32 eigens für die Strukturierung ist somit überflüssig. Zusätzlich besteht außerdem die Möglichkeit, die Strukturierungswalze 60 selbst zu beheizen, um einer lokalen Abkühlung der Oberfläche der elektrischen Leitung 32 durch die Strukturierungswalze 60 vorzubeugen.

Mittels einer nicht gezeigten Vorschubeinrichtung wird die elektrische Leitung 32 aus der Strangpressvorrichtung 48 heraus und an der sich drehenden Strukturierungswalze 60 vorbei geführt, um anschließend durch eine Kühlvorrichtung 58 geleitet zu werden. In der Kühlvorrichtung 58 wird die Temperatur der elektrischen Leitung 32 soweit reduziert, dass die nadelartigen Strukturen 64 erstarren, d.h. fixiert sind.

Nach der Kühlvorrichtung 58 wird die elektrische Leitung 32 an einer zweiten Walze 66 vorbeigeführt, deren Längsachse ebenfalls quer zur Längserstreckung der elektrischen Leitung 32 orientiert und deren Mantelfläche glatt ausgebildet ist. Die zweite Walze 66 steht mit dem Oberflächenbereich der elektrischen Leitung 32 in Berührung, in dem sich die nadelartigen Strukturen 64 befinden.

Die zweite Walze 66 ist heizbar und weist eine Temperatur auf, die ausreicht, um die nadelartigen Strukturen 64 zu verformen. Durch eine exakte Einstellung der Walzentemperatur und der Kraftwirkung der zweiten Walze 66 auf die elektrische Leitung 32, d.h. auf die nadelartige Struktur 64, lassen sich, wie in Fig. 5 gezeigt, die Spitzen 68 der nadelartigen Strukturen 64 entweder zu Haken umbiegen (Fig. 5a) oder pilzartig verbreitern (Fig. 5b), ohne dass die nadelartigen Strukturen 64 in einem unteren Abschnitt 70 wesentlich verformt werden, d.h. auseinander laufen oder zerfließen.

Obwohl in Fig. 4 die Herstellung einer elektrischen Leitung 32 gezeigt ist, die sechs nebeneinander angeordnete Kabelstränge aufweist, können mit Hilfe der Anordnung in Fig. 4 ebenso gut elektrische Leitungen mit rundem Querschnitt, flexible Flachkabel (FFC) oder flexible gedruckte Schaltkreise (FPC) mit klettverschlussartigen Haken versehen werden.

Sowohl der Fig. 3 als auch der Fig. 4 ist zu entnehmen, dass die elektrische Leitung 32 über annähernd ihre gesamte Breite mit Haken 40 und Ösen 46 versehen wird. Denkbar sind aber auch solche elektrische Leitungen 10, 32 aller drei Varianten, bei denen die Anordnung der Haken 18, 40 und Ösen 30, 46 auf einen oder mehrere vorbestimmte Oberflächenbereiche beschränkt ist. So können die Haken 18, 40 oder Ösen 30, 46 beispielsweise in Form eines sich in Längserstreckung der elektrischen Leitung 10, 32 erstreckenden schmalen Streifens oder in Abschnitten angeordnet sein, die in Längserstreckung der elektrischen Leitung 10, 32 zueinander beabstandet sind.

### Bezugszeichenliste

- 10: elektrische Leitung
- 12: elektrisch leitendes Material
- 14: elektrisch isolierendes Material
- 16: Außenseite
- 18: Haken
- 20: elektrisch isolierendes Material
- 22: elektrisch isolierendes Material
- 24: Außenseite
- 26: elektrisch isolierendes Material
- 28: Außenseite
- 30: Ösen
- 32: elektrische Leitung
- 34: elektrisch leitendes Material
- 36: elektrisch isolierendes Material
- 38: Oberfläche
- 40: Haken
- 42: erstes isolierendes Material
- 44: zweites isolierendes Material
- 46: Ösen
- 48: Strangpressvorrichtung
- 50: Isolationsummantelung
- 52: Austrittsöffnung
- 54: Andrückwalze
- 56: Struktur
- 58: Kühlvorrichtung
- 60: Strukturierungswalze
- 62: Mantelfläche
- 63: Nadelöffnungen
- 64: nadelartige Strukturen
- 66: zweite Walze
- 68: Spitzen
- 70: unterer Abschnitt

## Patentansprüche

1. Elektrische Leitung (10, 32) mit zumindest einem elektrisch leitenden Material (12, 34), das in wenigstens ein elektrisch isolierendes Material (14, 20, 22, 26, 36, 42, 44, 50) eingebettet ist, wobei die Oberfläche der elektrischen Leitung (10, 32) zumindest bereichsweise direkt und ohne Klebeverbindung in das elektrisch isolierende Material (14, 20, 22, 26, 36, 44, 50) integrierte klettverschlussartige Haken (18, 40) und/oder Ösen (30, 46) aufweist.

2. Elektrische Leitung nach Anspruch 1,
**dadurch gekennzeichnet,**
**dass** das elektrisch leitende Material (12) laminatartig zwischen zumindest zwei Schichten wenigstens eines elektrisch isolierenden Materials (14, 20, 22, 26) eingebettet ist, wobei zumindest eine der beiden Schichten durch eine wenigstens bereichsweise jeweils klettverschlussartige Haken (18) oder Ösen (30) aufweisende Struktur gebildet ist.

3. Elektrische Leitung nach Anspruch 2,
**dadurch gekennzeichnet,**
**dass** die eine Schicht (22) eine Haken (18) aufweisende und die andere Schicht (26) eine Ösen (30) aufweisende Struktur ist.

4. Elektrische Leitung nach Anspruch 2,
**dadurch gekennzeichnet,**
**dass** beide Schichten entweder Haken oder Ösen aufweisende Strukturen sind.

5. Elektrische Leitung nach einem der Ansprüche 2 bis 4,
**dadurch gekennzeichnet,**
**dass** die Schichten jeweils unterschiedliche elektrisch isolierende Materialien (20, 22; 22, 26) aufweisen.

6. Elektrische Leitung nach einem der Ansprüche 2 bis 5,
**dadurch gekennzeichnet,**
**dass** zumindest eine der Schichten (14, 20, 22, 26) eine Kunststofffolie aufweist.

7. Elektrische Leitung nach einem der Ansprüche 2 bis 6,
**dadurch gekennzeichnet ,**
**dass** zumindest eine der Schichten (14, 20, 22, 26) ein Gewebematerial aufweist.

8. Elektrische Leitung nach einem der vorherigen Ansprüche,
**dadurch gekennzeichnet,**
**dass** die elektrische Leitung (10) ein flexibles Flachbandkabel ist.

9. Elektrische Leitung nach einem der vorherigen Ansprüche,
**dadurch gekennzeichnet,**
**dass** die elektrische Leitung (10) eine flexible gedruckte Schaltung ist.

10. Elektrische Leitung nach Anspruch 1,
**dadurch gekennzeichnet,**
**dass** das elektrisch isolierende Material (36, 44, 50) zumindest bereichsweise mit einer klettverschlussartige Haken (40) oder Ösen (46) aufweisenden Struktur (56) versehen ist, die mit dem elektrisch isolierenden Material (36, 44, 50) eine Schmelzverbindung bildet.

11. Elektrische Leitung nach Anspruch 1,
**dadurch gekennzeichnet,**
**dass** die klettverschlussartigen Haken (40) aus dem elektrisch isolierenden Material (36, 44, 50) selbst gebildet sind.

12. Verfahren zum Versehen einer Oberfläche einer elektrischen Leitung (10, 32) mit klettverschlussartigen Haken (18, 40) oder Ösen (30, 46), bei dem
wenigstens ein elektrisch leitfähiges Material (12, 34) in zumindest ein elektrisch isolierendes Material (36, 42, 44, 50) eingebettet wird, wobei
das elektrisch isolierende Material (36, 42, 44) zumindest bereichsweise durch wenigstens eine klettverschlussartige Haken (40) oder Ösen (46) aufweisende Struktur (56) gebildet wird.

13. Verfahren nach Anspruch 12,
**dadurch gekennzeichnet,**
**dass** das elektrisch leitfähige Material (12) durch einen Laminiervorgang zwischen zumindest zwei Schichten wenigstens eines elektrisch isolierenden Materials (14, 20, 22, 26) eingebettet wird, wobei mindestens eine der Schichten durch eine wenigstens bereichsweise klettverschlussartige Haken (18) oder Ösen (30) aufweisende Struktur gebildet wird.

14. Verfahren nach Anspruch 12,
**dadurch gekennzeichnet,**
**dass** eine auf ihrer einen Seite klettverschlussartige Haken (40) oder Ösen (46) aufweisende Struktur (56) mit ihrer anderen Seite zumindest abschnittsweise auf die Oberfläche des elektrisch isolierenden Materials (36, 44, 50) aufgebracht wird, wobei das elektrisch isolierende Material (36, 44, 50) bei Aufbringen der Struktur eine derart hohe Temperatur aufweist, dass es mit der Struktur (56) eine Schmelzverbindung eingeht.

15. Verfahren zum Versehen einer Oberfläche einer elektrischen Leitung (32) mit klettverschlussartigen Haken (40), bei dem
wenigstens ein elektrisch leitfähiges Material (34) in zumindest ein elektrisch isolierendes Material (36, 44, 50) eingebettet wird und
zumindest bereichsweise direkt in dem elektrisch isolierenden Material (36, 44, 50) selbst klettverschlussartige Haken (40) gebildet werden.

16. Verfahren nach Anspruch 15,
**dadurch gekennzeichnet,**
**dass** in dem elektrisch isolierenden Material (36, 44, 50) selbst mittels eines ersten Strukturierungsmittels (60) nadelartige Strukturen (64) erzeugt werden.

17. Verfahren nach Anspruch 16,
**dadurch gekennzeichnet,**
**dass** die nadelartigen Strukturen (64) durch einen Prägevorgang erzeugt werden.

18. Verfahren nach Anspruch 16 oder 17,
**dadurch gekennzeichnet,**
**dass** die nadelartigen Strukturen (64) durch eine erste Walze (60) erzeugt werden, die mit einem Oberflächenbereich des elektrisch isolierenden Materials (36, 44, 50) in Berührung gebracht wird.

19. Verfahren nach einem der Ansprüche 16 bis 18,
**dadurch gekennzeichnet,**
**dass** die Bildung der nadelartigen Strukturen (64) bei einer Temperatur des elektrisch isolierenden Materials (36, 44, 50) erfolgt, bei der das elektrisch isolierende Material (36, 44, 50) leicht verformbar ist.

20. Verfahren nach einem der Ansprüche 12 bis 19,
**dadurch gekennzeichnet,**
**dass** die Spitzen (68) der nadelartigen Strukturen (64) mittels eines zweiten Strukturierungsmittels (66) zu Haken (40) umgeformt werden.

21. Verfahren nach Anspruch 20,
**dadurch gekennzeichnet,**
**dass** die Spitzen (68) der nadelartigen Strukturen (64) durch eine zur Längserstreckung der elektrischen Leitung (32) parallelen Relativbewegung der elektrischen Leitung (32) bezüglich einer zweiten Walze (66) umgebogen oder verbreitert werden.

22. Verfahren nach Anspruch 20 oder 21,
**dadurch gekennzeichnet,**
**dass** das Umformen der Spitzen (68) der nadelartigen Strukturen (64) nach einer Abkühlung des elektrisch isolierenden Materials (36, 44, 50) auf eine Temperatur erfolgt, bei der die nadelartigen Strukturen (64) erstarren, wobei das zweite Strukturierungsmittel (66) eine zur Verformung des elektrisch isolierenden Materials (36, 44, 50) benötigte Temperatur aufweist.

23. Verfahren nach einem der Ansprüche 14 bis 22,
**dadurch gekennzeichnet,**
**dass** zumindest ein elektrisch leitender Materialstrang (34) in einer Strangpressvorrichtung (48) mit wenigstens einer Kunststoffummantelung (50) versehen wird.

24. Verfahren nach einem der Ansprüche 14 bis 23,
**dadurch gekennzeichnet,**
**dass** das Versehen der elektrischen Leitung (32) mit den klettverschlussartigen Haken (40) oder Ösen (46) unmittelbar nach dem Austreten der elektrischen Leitung (32) aus einer Strangpressvorrichtung (48) erfolgt.

25. Anordnung zum Aufbringen einer klettverschlussartigen Haken (40) oder Ösen (46) aufweisenden Struktur (56) in zumindest einem Oberflächenbereich einer elektrischen Leitung (32), mit einer Strangpressvorrichtung (48) zum Versehen zumindest eines elektrisch leitenden Materialstrangs (34) mit wenigstens einer Kunststoffummantelung (50) und einer im Ausgangsbereich der Strangpressvorrichtung (48) angeordneten Andrückwalze (54) zum Andrücken einer an ihrer der elektrischen Leitung (32) abgewandten Seite klettverschlussartige Haken (40) oder Ösen (46) aufweisenden Struktur (56) an die elektrische Leitung (32), wobei die elektrische Leitung (32) mit der Struktur (56) eine Schmelzverbindung eingeht.

26. Anordnung zum Versehen zumindest eines Oberflächenbereiches einer elektrischen Leitung (32) mit klettverschlussartigen Haken (40), mit einer Strangpressvorrichtung (48) zum Versehen zumindest eines elektrisch leitenden Materialstrangs (34) mit wenigstens einer Kunststoffummantelung (50), einem im Ausgangsbereich der Strangpressvorrichtung (48) angeordneten ersten und zweiten Strukturierungsmittel (60, 66), einer zwischen den Strukturierungsmitteln (60, 66) angeordneten Kühlvorrichtung (58) zum Abkühlen der elektrischen Leitung (32) und einer Vorschubeinrichtung, um die elektrische Leitung (32) an den Strukturierungsmitteln (60, 66) vorbei und durch die Kühlvorrichtung (58) hindurch zu führen.

27. Anordnung nach Anspruch 26,
**dadurch gekennzeichnet,**
**dass** das erste Strukturierungsmittel eine, insbesondere heizbare, Walze (60) ist, deren Mantelfläche (62) insbesondere mit Nadelöffnungen (63) versehen ist, um in dem Oberflächenbereich nadelartige Strukturen (64) zu erzeugen.

28. Anordnung nach Anspruch 27,
**dadurch gekennzeichnet,**
**dass** das zweite Strukturierungsmittel eine heizbare Walze (66) ist, deren Mantelfläche insbesondere glatt ausgebildet ist, um die nadelartigen Strukturen (64) zu Haken (40) umzuformen.

## Claims

1. Electrical line (10, 32) with at least one electrical conductive material (12, 34), embedded in at least one electrical insulating material (14, 20, 22, 26, 36, 42, 44, 50), the surface of the electrical line (10, 32) comprising at least partially hook-and-loop type hooks (18, 40) and/or loops (30, 46), integrated at least partially direct and without adhesive bond in the electrical insulating material (14, 20, 22, 26, 36, 44, 50).

2. Electrical line according to claim 1,
**characterized in that** the electrical conductive material (12) is embedded in laminate form between at least two layers of at least one electrical insulating material (14, 20, 22, 26), at least one of the two layers is formed by a structure comprising at least partially hook-and-loop type hooks (18) or loops (30), respectively.

3. Electrical line according to claim 2,
**characterized in that** one layer (22) is a hooks (18) comprising structure and the other layer (26) is a loops (30) comprising structure.

4. Electrical line according to claim 2,
**characterized in that** both layers are either hooks or loops comprising structures.

5. Electrical line according to one of the claims 2 to 4,
**characterized in that** the layers respectively comprising different electrical insulating materials (20, 22; 22, 26).

6. Electrical line according to one of the claims 2 to 5,
**characterized in that** at least one of the layers (14, 20, 22, 26) comprises a plastic foil.

7. Electrical line according to one of the claims 2 to 6,
**characterized in that** at least one of the layers (14, 20, 22, 26) comprises a fabric material.

8. Electrical line according to one of the previous claims,
**characterized in that** the electrical line (10) is a flexible ribbon cable.

9. Electrical line according to one of the previous claims,
**characterized in that** the electrical line (10) is a flexible printed circuit.

10. Electrical line according to claim 1,
**characterized in that** the electrical insulating material (36, 44, 50) is provided at least partially with a structure (56) comprising hook-and-loop type hooks (40) or loops (46), forming a fusion joint with the electrical insulating material (36, 44, 50).

11. Electrical line according to claim 1,
**characterized in that** the hook-and-loop type hooks (40) are formed of the electrical insulating material (36, 44, 50) itself.

12. Method for providing a surface of an electrical line (10, 32) with hook-and-loop type hooks (18, 40) or loops (30, 46), wherein
at least one electrical conductive material (12, 34) is embedded in at least one electrical insulating material (36, 42, 44, 50), wherein
the electrical insulating material (36, 42, 44) is formed at least partially by at least one structure (56) comprising hook-and-loop type hooks (40) or loops (46).

13. Method according to claim 12,
**characterized in that** the electrical conductive material (12) is embedded by a laminating process between at least two layers of at least one electrical insulating material (14, 20, 22, 26), at least one of the layers is formed by a structure comprising at least partially hook-and-loop type hooks (18) or loops (30).

14. Method according to claim 12,
**characterized in that** a structure (56) comprising on one side hook-and-loop type hooks (40) or loops (46) is applied with its other side at least in sections on the surface of the electrical insulating material (36, 44, 50), wherein the electrical insulating material (36, 44, 50) having such a high temperature at application of the structure that it forms a fusion joint with the structure (56).

15. Method for providing the surface of an electrical line (32) with hook-and-loop type hooks (40), wherein
at least one electrical conductive material (34) is embedded in at least one electrical insulating material (36, 44, 50), and
hook-and-loop type hooks (40) are formed at least partially directly in the electrical insulating material (36, 44, 50) itself.

16. Method according to claim 15,
**characterized in that** in the electrical insulating material (36, 44, 50) itself needle-like structures (64) are formed by means of a first structuring means (60).

17. Method according to claim 16,
**characterized in that** the needle-like structures (64) are formed by an embossing process.

18. Method according to claim 16 or 17,
**characterized in that** the needle-like structures (64) are formed by a first roller (60), which is brought in contact with a surface area of the electrical insulating material (36, 44, 50).

19. Method according to one of the claims 16 to 18,
**characterized in that** the forming of the needle-like structures (64) is performed at a temperature of the electrical insulating material (36, 44, 50) where the electrical insulating material (36, 44, 50) is easily deformable.

20. Method according to one of the claims 12 to 19,
**characterized in that** the tips (68) of the needle-like structures (64) are reshaped to hooks (40) by means of a second structuring means (66).

21. Method according to claim 20,
**characterized in that** the tips (68) of the needle-like structures (64) are bent or broadened by a relative movement of the electrical line (32) parallel to the longitudinal extent of the electrical line (32) relative to a second roller (66).

22. Method according to claim 20 or 21,
**characterized in that** the reshaping of the tips (68) of the needle-like structures (64) is taking place after cooling of the electrical insulating material (36, 44, 50) to a temperature, where the needle-like structures (64) solidify, wherein the second structuring means (66) has a temperature required for deformation of the electrical insulating material (36, 44, 50).

23. Method according to one of the claims 14 to 22,
**characterized in that** at least one electrical conductive material strand (34) is provided with at least one plastic coating (50) in an extruding device (48).

24. Method according to one of the claims 14 to 23,
**characterized in that** the provision of the electrical line (32) with the hook-and-loop type hooks (40) or loops (46) takes place immediately after the electrical line (32) leaves from an extruding device (48).

25. Arrangement for applying a structure (56) comprising hook-and-loop type hooks (40) or loops (46) in at least one surface area of an electrical line (32), comprising an extruding device (48) for providing at least one electrical conductive material strand (34) with at least one plastic coating (50) and a pressure roll (54) disposed in the output region of the extruding device (48) for pressing a structure (56) comprising hook-and-loop type hooks (40) or loops (46) on the side opposite to the electrical line (32) against the electrical line (32) wherein the electrical line (32) forms a fusion joint with the structure (56).

26. Arrangement for provision of at least one surface area of an electrical line (32) with hook-and-loop type hooks (40), comprising an extruding device (48) for providing at least one electrical conductive material strand (34) with at least one plastic coating (50), a first and second structuring means (60, 66) disposed in the output region of the extruding device (48), a cooling apparatus (58) disposed between the structuring means (60, 66) for cooling the electrical line (32), and a feeding device for routing the electrical line (32) past the structuring means (60, 66) and through the cooling apparatus (58).

27. Arrangement according to claim 26,
**characterized in that** the first structuring means is a roller (60), in particular a heatable roller, whose surface area (62) is provided with needle openings (63) in particular, to form needle-like structures (64) in the surface area.

28. Arrangement according to claim 27,
**characterized in that** the second structuring means is a heatable roller (66), whose surface area is smooth in particular, to reshape the needle-like structures (64) into hooks (40).

## Revendications

1. Ligne électrique (10, 32) comprenant au moins un matériau électriquement conducteur (12, 34), qui est noyé dans au moins un matériau électriquement isolant (14, 20, 22, 26, 36, 42, 44, 50), la surface de la ligne électrique (10, 32) comprenant au moins localement des crochets (18, 40) et/ou des oeillets (30, 46) intégrés directement et sans jonction collée dans le matériau électriquement isolant (14, 20, 22, 26, 36, 44, 50).

2. Ligne électrique selon la revendication 1,
**caractérisée en ce que** le matériau électriquement conducteur (12) est noyé de manière stratifiée entre au moins deux couches d'au moins un matériau électriquement isolant (14, 20, 22, 26), l'une des deux couches au moins étant formée par une structure qui présente au moins localement respectivement des crochets (18) ou des oeillets (30) à la manière d'une fermeture agrippante.

3. Ligne électrique selon la revendication 2,
**caractérisée en ce qu'**une couche (22) est une structure présentant des crochets (18) et l'autre couche (26) est une structure présentant des oeillets (30).

4. Ligne électrique selon la revendication 2,
**caractérisée en ce que** les deux couches sont des structures présentant soit des crochets soit des oeillets.

5. Ligne électrique selon l'une des revendications 2 à 4,
**caractérisée en ce que** les couches présentent respectivement des matériaux électriquement isolants différents (20, 22 ; 22, 26).

6. Ligne électrique selon l'une des revendications 2 à 5,
**caractérisée en ce que** l'une au moins des couches (14, 20, 22, 26) présente un film en matière plastique.

7. Ligne électrique selon l'une des revendications 2 à 6,
**caractérisée en ce que** l'une au moins des couches (14, 20, 22, 26) comprend un matériau textile.

8. Ligne électrique selon l'une des revendications précédentes,
**caractérisée en ce que** la ligne électrique (10) est un câble flexible à ruban plat.

9. Ligne électrique selon l'une des revendications précédentes,
**caractérisée en ce que** la ligne électrique (10) est un circuit imprimé flexible.

10. Ligne électrique selon la revendication 1,
**caractérisée en ce que** le matériau électriquement isolant (36, 44, 50) est doté au moins localement d'une structure présentant des crochets (40) ou des oeillets (46) à la manière d'une fermeture agrippante, cette structure formant une jonction à fusion avec le matériau électriquement isolant (36, 44, 50).

11. Ligne électrique selon la revendication 1,
**caractérisée en ce que** les crochets (40) à la manière d'une fermeture agrippante sont formés à partir du matériau électriquement isolant (36, 44, 50) lui-même.

12. Procédé pour doter une surface d'une ligne électrique (10, 32) de crochets (18, 40) ou d'oeillets (30, 46) à la manière d'une fermeture agrippante, dans lequel
au moins un matériau électriquement conducteur (12, 34) est noyé dans au moins un matériau électriquement isolant (36, 42, 44, 50), et
le matériau électriquement isolant (36, 42, 44) est formé au moins localement par une structure (56) présentant des crochets (40) ou des oeillets (46) à la manière d'une fermeture agrippante.

13. Procédé selon la revendication 12,
**caractérisé en ce que** le matériau électriquement conducteur (12) est noyé, par une opération de stratification, entre au moins deux couches d'au moins un matériau électriquement isolant (14, 20, 22, 26), l'une au moins des couches étant formée par une structure présentant au moins localement des crochets (18) ou des oeillets (30) à la manière d'une fermeture agrippante.

14. Procédé selon la revendication 12,
**caractérisé en ce qu'**une structure (56), qui présente sur l'un de ces côtés des crochets (40) ou des oeillets (46) à la manière d'une fermeture agrippante est appliquée par son autre côté au moins localement sur la surface du matériau électriquement isolant (36, 44, 50), le matériau électriquement isolant (36, 44, 50) présentant lors de l'application de la structure une température aussi élevée qu'il établit une jonction par fusion avec la structure (56).

15. Procédé pour doter une surface d'une ligne électrique (32) de crochets (40) à la manière d'une fermeture agrippante, dans lequel
au moins un matériau électriquement conducteur (34) est noyé dans au moins un matériau électriquement isolant (36, 44, 50), et
des crochets (40) à la manière d'une fermeture agrippante sont formés au moins localement directement dans le matériau électriquement isolant (36, 44, 50) lui-même.

16. Procédé selon la revendication 15,
**caractérisé en ce que** des structures (64) semblables à des aiguilles sont engendrées dans le matériau électriquement isolant (36, 44, 50) lui-même au moyen d'un premier moyen de structuration (60).

17. Procédé selon la revendication 16,
**caractérisé en ce que** les structures (64) semblables à des aiguilles sont engendrées par une opération d'estampage.

18. Procédé selon la revendication 16 ou 17,
**caractérisé en ce que** les structures (64) semblables à des aiguilles sont engendrées par un premier cylindre (60) qui est amené en contact avec une zone de la surface du matériau électriquement isolant (36, 44, 50).

19. Procédé selon l'une des revendications 16 à 18,
**caractérisé en ce que** la formation des structures (64) semblables à des aiguilles a lieu à une température du matériau électriquement isolant (36, 44, 50) à laquelle le matériau électriquement isolant (36, 44, 50) est aisément déformable.

20. Procédé selon l'une des revendications 12 à 19,
**caractérisé en ce que** les pointes (68) des structures (64) semblables à des aiguilles sont transformées en crochets (40) au moyen d'un second moyen de structuration (66).

21. Procédé selon la revendication 20,
**caractérisé en ce que** les pointes (68) des structures (64) semblables à des aiguilles sont recourbées ou élargies par un mouvement relatif, parallèle à l'extension longitudinale de la ligne électrique (32), de la ligne électrique (32) par rapport à un second cylindre (66).

22. Procédé selon la revendication 20 ou 21,
**caractérisé en ce que** la transformation des pointes (68) des structures (64) semblables à des aiguilles a lieu après un refroidissement du matériau électriquement isolant (36, 44, 50) jusqu'à une température à laquelle les structures (64) semblables à des aiguilles se figent, et le second moyen de structuration (66) présente une température nécessaire pour la déformation du matériau électriquement isolant (36, 44, 50).

23. Procédé selon l'une des revendications 14 à 22,
**caractérisé en ce qu'**au moins un brin de matériau électriquement conducteur (34) est pourvu d'au moins un enrobage en matière plastique (50) dans un appareil d'extrusion (48).

24. Procédé selon l'une des revendications 14 à 23,
**caractérisé en ce que** l'opération consistant à doter la ligne électrique (32) des crochets (40) ou des oeillets (46) à la manière d'une fermeture agrippante a lieu immédiatement après la sortie de la ligne électrique (32) hors d'un appareil d'extrusion (48).

25. Système pour appliquer une structure (56) présentant des crochets (40) ou des oeillets (46) à la manière d'une fermeture agrippante dans au moins une zone de surface d'une ligne électrique (32), comprenant un appareil d'extrusion (48) pour doter au moins un brin de matériau électriquement conducteur (34) d'au moins un enrobage en matière plastique (50), et un cylindre presseur (54) agencé dans la zone de sortie de l'appareil d'extrusion (48) pour presser contre la ligne électrique (32) une structure (56) qui présente des crochets (40) ou des oeillets (46) à la manière d'une fermeture agrippante sur son côté tourné vers la ligne électrique (32), la ligne électrique (32) établissant une jonction par fusion avec la structure (56).

26. Système pour doter au moins une zone de surface d'une ligne électrique (32) de crochets (40) à la manière d'une fermeture agrippante, comprenant un appareil d'extrusion (48) pour doter au moins un brin de matériau électriquement conducteur (34) d'au moins un enrobage en matière plastique (50), un premier et un second moyen de structuration (60, 66) agencés dans la zone de sortie de l'appareil d'extrusion (48), un dispositif de refroidissement (58) agencé entre les moyens de structuration (60, 66) pour refroidir la ligne électrique (32), et un dispositif d'avance pour faire passer la ligne électrique (32) le long des moyens de structuration (60, 66) et à travers le dispositif de refroidissement (58).

27. Système selon la revendication 26,
**caractérisé en ce que** le premier moyen de structuration est un cylindre (60), en particulier chauffable, dont la surface enveloppe (62) est en particulier dotée d'ouverture d'aiguilles (63), afin d'engendrer des structures (64) semblables à des aiguilles dans la zone de surface.

28. Système selon la revendication 27,
**caractérisé en ce que** le second moyen de structuration est un cylindre chauffable (66), dont la surface enveloppe est réalisée en particulier lisse, afin de transformer les structures (64) semblables à des aiguilles en crochets (40).
